# EUROPÄISCHE PATENTSCHRIFT

(11) **EP 3 035 066 B1**
(45) Veröffentlichungstag und Bekanntmachung des Hinweises auf die Patenterteilung: **10.10.2018**
(21) Anmeldenummer: 14199011.9
(22) Anmeldetag: 18.12.2014
(51) Int. Cl.: G01R 31/36

(54) **Überwachungsvorrichtung**
Monitoring device
Dispositif de surveillance

(43) Veröffentlichungstag der Anmeldung: 22.06.2016
(73) Patentinhaber: Samsung SDI Co., Ltd., Yongin-si, Gyeonggi-do (KR)
(72) Erfinder: Golubkov, Andrej, 8010 Graz (AT)
(74) Vertreter: Gulde & Partner

(56) Entgegenhaltungen:
- EP-A2- 2 538 234
- DE-A1-102010 001 374
- US-A1- 2014 147 713

## Beschreibung

### Gebiet der Erfindung

Die vorliegende Erfindung betrifft eine Überwachungsvorrichtung für ein Energiespeichersystem und ein Verfahren zur Überwachung eines Energiespeichersystems.

### Stand der Technik

Sowohl im stationären Betrieb, wie auch in der Fahrzeugindustrie kommen vermehrt Energiespeichersysteme unterschiedlichster Ausgestaltungen zum Einsatz.

Insbesondere auf wiederaufladbaren Batterien basierende Energiespeichersysteme (Batteriesysteme) finden bereits in vielen Elektro- und Hybridfahrzeugen Verwendung. Ein solches Batteriesystem umfasst für gewöhnlich eine Vielzahl von wiederaufladbaren Zellen (Batteriezellen). Die Zellen werden je nach Anforderung in Serie oder parallel geschaltet und so zu einzelnen Zellmodulen zusammengefasst. Die Zellmodule wiederum können ebenso untereinander in Serie oder parallel zu einem Modulverbund verschaltet werden. Der Modulverbund stellt das Herz eines jeden Batteriesystems dar.

Im Besonderen im Kraftfahrzeugsektor werden an ein Batteriesystem hohe Anforderungen, vor allem in Bezug auf Sicherheit und Zuverlässigkeit, gestellt. Daraus ergibt sich die Notwendigkeit jede einzelne Zelle des Batteriesystems in vorgegebenen Betriebsbereichen in Bezug auf Spannung, Temperatur und Strom zu betreiben.

In der Regel werden an jedem Modul sogenannte CSCs "Cell Supervision Circuits" angeordnet, die Zelldaten, wie zum Beispiel Zellspannungen, erfassen und diese über eine Busverbindung an eine Batteriemanagementeinheit ("Battery Management Unit") weitergeben. Die Batteriemanagementeinheit dient der Überwachung des Batteriesystems.

Die Veröffentlichung DE 10 2010 040 721 A1 beschreibt beispielsweise ein Batteriesystem, ein Verfahren zum Überwachen eines Batteriesystems, sowie ein Kraftfahrzeug mit einem Batteriesystem. Innerhalb des Batteriesystems ist jeder Zelle eine Zellspannungserfassungsschaltung zugeordnet, diese sind mit einem Multiplexer verbunden, wobei ein Ausgang des Multiplexers mit einem AD-Wandler verbunden ist, der wiederum mit einem Kommunikationsbus mit einer Auswerteeinheit verbunden ist. Zusätzlich ist der Multiplexer mit wenigstens einer der Auswerteeinheit bekannten Hilfsspannungsquelle verbunden. In diesem Dokument steht die genaue Messung bzw. Überwachung der Zellspannungen im Vordergrund. Weitere zu überwachende Größen, wie beispielsweise die Zelltemperatur, werden nicht erfasst.

Das Dokument WO 2009/080686 beschreibt eine Überwachungsschaltung für ein Energiespeichersystem. Auch hier steht die Spannungsmessung der Zellen im Vordergrund.

In der Regel findet in derzeitigen Energiespeichersystemen eine Temperaturüberwachung mittels Thermoelementen statt, jedoch nur an wenigen Stellen innerhalb des Energiespeichersystems - eine (Einzel-)Zellen Temperaturüberwachung ist nicht gegeben. Dies birgt zum einen den Nachteil, dass im Fehlerfall eine Überhitzung einer Zelle erst spät erkannt wird und zum anderen die Leistung des Energiespeichersystems nicht vollständig genutzt wird.

Thermoelemente müssen zudem in eigenen Arbeitsschritten im Energiespeichersystem verkabelt und verklebt werden, was eine unnötige Erweiterung des Zusammenbauaufwands bedingt.

Die EP 2 538 234 A2 beschreibt ein Verfahren zur Überwachung eines Energiespeichersystems, wobei das Energiespeichersystem eine Steuereinheit und mehrere Zellen aufweist, die jeweils einen ersten Anschluss und einen zweiten Anschluss aufweisen, wobei der erste Anschluss einer ersten Zelle mit dem zweiten Anschluss einer zweiten Zelle mittels jeweils einem Verbindungselement verbunden ist und durch die Steuereinheit zumindest eine jeweilige mittlere Zelltemperatur der über das jeweilige Verbindungselement verbundenen Zellen berechnet wird. Über Konverter werden analoge Spannungs- und Stromwerte in digitale Signale gewandelt.

### Aufgabenstellung

Es ist eine erste Aufgabe der Erfindung eine Überwachungsvorrichtung für ein Energiespeichersystem anzugeben mit der auf einfache Weise eine zuverlässige Überwachung der Zellspannung und der Zelltemperatur erfolgen kann. Eine weitere Aufgabe der Erfindung besteht darin ein zuverlässiges Verfahren zur Überwachung eines Energiespeichersystems vorzustellen.

Die Lösung der ersten Aufgabe erfolgt durch die Merkmale des unabhängigen Anspruchs 1. Die Lösung der weiteren Aufgabe erfolgt durch die Merkmale des unabhängigen Anspruchs 16.

Weiterbildungen der Erfindung sind in den abhängigen Ansprüchen, der Beschreibung sowie den beigefügten Zeichnungen angegeben.

Die Lösung der ersten Aufgabe erfolgt somit durch eine Überwachungsvorrichtung für ein Energiespeichersystem, wobei das Energiespeichersystem mehrere Zellen aufweist, die jeweils einen ersten Anschluss und einen zweiten Anschluss aufweisen, wobei der erste Anschluss einer ersten Zelle mit dem zweiten Anschluss einer zweiten Zelle mittels jeweils einem Verbindungselement verbunden ist, wobei jedes Verbindungselement über jeweils eine Multiplexer-Verbindungsleitung mit einem Multiplexer verbunden ist, wobei in zumindest einer Multiplexer-Verbindungsleitung ein temperaturabhängiger Widerstand angeordnet ist, der in thermischem Kontakt mit zumindest einer Zelle (2,13,14) steht, wobei der Multiplexer über zwei AD-Verbindungsleitungen mit einem AD-Wandler verbunden ist und die zwei AD-Verbindungsleitungen über einen schaltbaren Schaltwiderstand verbindbar sind, wobei der zuschaltbare oder wegschaltbarer Schaltwiderstand parallel zu dem AD-Wandler angeordnet ist derart, dass
die zwei AD-Verbindungsleitungen über den Schaltwiderstand verbindbar sind, und der Schaltwiderstand über eine Steuereinheit schaltbar ist.
Unter dem Begriff "verbunden" ist in der vorliegenden Erfindung insbesondere elektrisch verbunden zu verstehen. Wird lediglich eine konstruktive Verbindung beschrieben wird gesondert darauf hingewiesen.

Erfindungsgemäß ist die Überwachungsvorrichtung für den Einsatz in einem Energiespeichersystem vorgesehen. Das Energiespeichersystem umfasst mehrere Zellen, die in Serie geschaltet sind.

Unter dem Begriff "Zellen" sind insbesondere Batteriezellen zu verstehen.

Jede Zelle weist im Allgemeinen zwei Pole, auch Anschlüsse genannt, auf - einen Pluspol und einen Minuspol.

Erfindungsgemäß weist somit jede Zelle der mehreren Zellen des Energiespeichersystems zwei Anschlüsse (Pole) auf - einen ersten Anschluss (Pol) und einen zweiten Anschluss (Pol), wobei der erste Anschluss somit den Pluspol einer Zelle und der zweite Anschluss den Minuspol einer Zelle darstellt, oder umgekehrt.

Bei einer Schaltung der Zellen in Reihe (Reihenschaltung oder Serienschaltung) wird im Allgemeinen der Pluspol einer Zelle mit dem Minuspol einer nächsten Zelle usw. verbunden.

In der vorliegenden Erfindung sind die Zellen des zu überwachenden Energiespeichersystems erfindungsgemäß in Reihe (in Serie) geschaltet, das heißt der erste Anschluss einer ersten Zelle ist mit dem zweiten Anschluss einer zweiten (nächsten) Zelle usw. verbunden.

Die jeweiligen Verbindungen des ersten Anschlusses der ersten Zelle mit dem zweiten Anschluss der zweiten Zelle usw. erfolgt jeweils über ein elektrisch leitfähiges Verbindungselement, auch "Busbar" genannt.

Erfindungsgemäß ist jedes Verbindungselement über eine Multiplexer-Verbindungsleitung mit einem Multiplexer verbunden. Der Multiplexer stellt nach allgemeinem Stand der Technik eine Selektionsschaltung dar, mit der aus einer Anzahl von Eingangssignalen eines oder mehrere ausgewählt und an einen oder mehrere Ausgänge durchgeschaltet werden kann/können. Die Schaltung erfolgt mittels elektronischer Signale.

Gemäß der vorliegenden Erfindung ist in zumindest einer Multiplexer-Verbindungsleitung, d.h. in zumindest einer der jeweiligen Verbindungsleitungen zwischen dem jeweiligen Verbindungselement und dem Multiplexer (Eingangsleitung), ein temperaturabhängiger Widerstand angeordnet.

Besonders bevorzugt umfasst die erfindungsgemäße Überwachungsvorrichtung in jeder zweiten Multiplexer-Verbindungsleitung jeweils einen temperaturabhängigen Widerstand.

Des Weiteren besonders bevorzugt ist in jeder Multiplexer-Verbindungsleitung jeweils ein temperaturabhängiger Widerstand angeordnet.

Der temperaturabhängige Widerstand steht in thermischem Kontakt mit dem Verbindungselement, wobei der temperaturabhängige Widerstand mit dem Verbindungselement über die Multiplexer-Verbindungsleitung auch elektrisch verbunden ist.

Der Multiplexer weist erfindungsgemäß zwei Ausgangsleitungen auf. Diese beiden Ausgangsleitungen werden als AD-Verbindungsleitungen bezeichnet und verbinden den Multiplexer mit einem AD-Wandler.

Der AD-Wandler arbeitet in einer für AD-Wandler allgemein bekannten Funktion - er setzt analoge Eingangssignale in digitale Daten um, die dann weiterverarbeitet, oder gespeichert werden können.

Die zwei AD-Verbindungsleitungen sind über einen schaltbaren Schaltwiderstand verbindbar.

In einer vorteilhaften Ausführungsvariante der vorliegenden Erfindung ist der Schaltwiderstand parallel zum AD-Wandler angeordnet.

Gemäß einer überaus vorteilhaften Ausführungsform der erfindungsgemäßen Überwachungsvorrichtung ist der Schaltwiderstand über eine Steuereinheit schaltbar, wobei der Schaltwiderstand zuschaltbar oder wegschaltbar ist.

Vorzugsweise ist der schaltbare Widerstand als Präzisionsswiderstand mit hoher Genauigkeit und geringer Temperaturabhängigkeit des Widerstandwertes ausgeführt.

Der schaltbare Widerstand kann zugeschaltet werden, wobei in diesem Fall die beiden AD-Verbindungsleitungen verbunden sind, und der schaltbare Widerstand kann weggeschaltet werden, wobei so die beiden AD-Verbindungsleitungen nicht verbunden sind.

Die Steuereinheit ist vorzugsweise mit dem AD-Wandler verbunden.

Über die Steuereinheit ist zum einen der Multiplexer und zum anderen der Schaltwiderstand schaltbar (zuschaltbar und wegschaltbar).

Mittels des Multiplexers und/oder durch die Steuereinheit werden Messsignale der Zellen der Reihe nach zum AD-Wandler durchgeschaltet.

Die Steuereinheit ist besonders bevorzugt so eingerichtet, dass eine Zellklemmenspannung messbar ist, wenn der Schaltwiderstand weggeschaltet ist.

Des Weiteren ist die Steuereinheit besonders bevorzugt so eingerichtet, dass eine Zelltemperatur berechenbar ist, wenn der Schaltwiderstand zugeschaltet ist und die Zellklemmenspannung zuvor gemessen und gespeichert wurde.

Darüber hinaus ist die Steuereinheit besonders bevorzugt so eingerichtet, dass ein Ladungsausgleich zwischen den Zellen durchführbar ist, wenn der Schaltwiderstand zugeschaltet ist und der Multiplexer derart geschaltet ist, dass ein ausreichend großes Zeitfenster für eine Entladung einer Zelle bereitgestellt wird.

Die erfindungsgemäße Überwachungsvorrichtung ermöglicht somit zum einen die Überwachung der (Einzel-)Zellspannung und (Einzel-) Zelltemperatur und zum anderen auch einen Ladungsausgleich zwischen den Zellen ("Balancing"). Umso exakter bzw. umso mehr (Einzel-) Zelltemperaturen bekannt sind, desto zuverlässiger können maximale und minimale Temperaturen in einem Energiespeichersystem erkannt werden. Somit kann zum einen ein sicherer Betrieb des Energiespeichersystems gewährleistet werden und zum anderen ist es möglich das Energiespeichersystem bzw. dessen Leistung möglichst vollständig zu nutzen ohne dieses dabei nachhaltig zu schädigen.

Zum anderen erfolgt die Lösung der weiteren Aufgabe der vorliegenden Erfindung durch ein Verfahren zur Überwachung eines Energiespeichersystems, wobei das Energiespeichersystem eine Steuereinheit und mehrere Zellen aufweist, die jeweils einen ersten Anschluss und einen zweiten Anschluss aufweisen, wobei der erste Anschluss einer ersten Zelle mit dem zweiten Anschluss einer zweiten Zelle mittels jeweils einem Verbindungselement verbunden ist, wobei durch die Steuereinheit zumindest eine jeweilige mittlere Zelltemperatur der über das jeweilige Verbindungselement verbundenen ersten Zelle und der zweiten Zelle berechnet wird, wobei,die jeweilige mittlere Zelltemperatur mittels jeweils einem temperaturabhängigen Widerstand über die jeweilige gemessene Zellspannung der Zelle und einen jeweiligen berechneten Strom durch einen zugeschalteten Schaltwiderstand berechnet wird.

Erfindungsgemäß dient das Verfahren der Überwachung eines Energiespeichersystems, genauer der Überwachung der Zellen des Energiespeichersystems. Das Energiespeichersystem weist mehrere Zellen auf, die, wie bereits zuvor beschrieben, in Reihe geschaltet sind. Zudem umfasst das Energiespeichersystem eine Steuereinheit.

Erfindungsgemäß ist vorgesehen, dass durch die Steuereinheit zumindest eine jeweilige mittlere Zelltemperatur der über das jeweilige Verbindungselement verbundenen ersten Zelle und der zweiten Zelle berechnet wird.

In einem besonders vorteilhaften Verfahren wird die jeweilige mittlere Zelltemperatur mittels jeweils einem temperaturabhängigen Widerstand über eine gemessene jeweilige Zellspannung und einen jeweiligen Strom durch einen zugeschalteten Schaltwiderstand berechnet.

Besonders vorteilhaft ist ebenso, wenn der jeweilige Strom durch den zugeschalteten Schaltwiderstand über eine mittels eines AD-Wandlers ermittelte jeweilige Spannung am zugeschalteten Schaltwiderstand berechnet wird.

Es ist als besonders günstig zu erachten, wenn die gemessenen Zellspannungen mittels eines Multiplexers der Reihe nach zu dem AD-Wandler durchgeschaltet werden.

Durch die erfindungsgemäße Überwachungsvorrichtung ergibt sich der Vorteil auf einfache Art und Weise eine Überwachung von mehreren Zellen innerhalb eines Batteriesystems in Bezug auf Einzel-Zellspannungen, Einzel-Zelltemperaturen und Zell-Ladungsausgleich zu erzielen.

### Kurzbeschreibung der Zeichnungen

Die Erfindung wird im Folgenden beispielhaft unter Bezugnahme auf die Zeichnungen beschrieben.
- Fig.: zeigt eine Ausführung der erfindungsgemäßen Überwachungsvorrichtung.

### Detaillierte Beschreibung der Erfindung

In der FIG. ist eine zur näheren Erläuterung der erfindungsgemäßen Überwachungsvorrichtung 1 eine mögliche Ausführungsform schematisch dargestellt.

Das Energiespeichersystem mit mehreren Zellen 2, 13, 14 ist in der FIG. lediglich schematisch durch vier in Reihe geschaltete Zellen 2, 13, 14 dargestellt.

Jede Zelle 2, 13, 14 weist jeweils zwei Anschlüsse 3, 4 auf - einen ersten Anschluss 3 und einen zweiten Anschluss 4. In der vorliegenden Darstellung ist der erste Anschluss 3 der Minuspol der Zelle 2, 13, 14 und der zweite Anschluss 4 der Pluspol der Zelle 2, 13, 14.

Die Zellen, 2, 13, 14 sind in Reihe geschaltet, wobei der erste Anschluss 3 einer ersten Zelle 2, 13 mit dem zweiten Anschluss 4 einer zweiten Zelle 2, 14 usw. verbunden ist.

Die Verbindung des ersten Anschlusses 3 der ersten Zelle 2, 13 mit dem zweiten Anschluss 4 der zweiten Zelle 2, 14 usw. erfolgt jeweils über ein Verbindungselement 5.

Das jeweilige Verbindungselement 5 ist über eine Multiplexer-Verbindungsleitung 6 mit einem Multiplexer 7 verbunden.

In jeder zweiten Multiplexer-Verbindungsleitung 6 ist jeweils ein temperaturabhängiger Widerstand 8 angeordnet.

Der Multiplexer 7 weist zwei AD-Verbindungsleitungen 9 (zwei Ausgänge) auf, wobei über die zwei AD-Verbindungsleitungen der Multiplexer 7 mit einem AD-Wandler verbunden ist.
Der AD-Wandler 10 wiederum ist mit einer Steuereinheit 12 verbunden.

Die beiden AD-Verbindungsleitungen 9 sind über einen schaltbaren Widerstand 11 verbindbar. Der schaltbare Widerstand 11 kann zugeschaltet werden, wobei in diesem Fall die beiden AD-Verbindungsleitungen 9 verbunden sind, und der schaltbare Widerstand 11 kann weggeschaltet werden, wobei so die beiden AD-Verbindungsleitungen 9 nicht verbunden sind.

Die Steuereinheit 12 steuert zum einen den Multiplexer 7 und zum anderen den schaltbaren Widerstand 11.

Bei weggeschalteten Widerstand 11 misst der AD-Wandler 10 die Klemmspannung der durch den Multiplexer 7 zugeschalteten Zelle 2, 13, 14. Der gemessene Wert der Klemmspannung der zugeschalteten Zelle 2, 13, 14 wird im Steuergerät 12 gespeichert.

Ein erfindungsgemäßes Verfahren zur Überwachung des Energiespeichersystems mit mehreren Zellen 2, 13, 14 nutzt die Steuereinheit 12, wobei zumindest eine mittlere Zelltemperatur einer über ein Verbindungselement 5 verbundenen ersten Zelle 2, 13 und einer zweiten Zelle 2, 14 berechnet wird. Der schaltbare Schaltwiderstand 11 ist mittels der Steuereinheit 12 zugeschaltet - die beiden AD-Verbindungsleitungen 9 sind verbunden und der AD-Wandler 10 misst eine Spannung an dem schaltbaren Schaltwiderstand 11. Damit wird durch das Steuergerät 12 mittels der bekannten Widerstandsgröße des Schaltwiderstands 11 auf einen Strom durch den Schaltwiderstand 11 geschlossen.
Der Strom durch den Schaltwiderstand 11 hängt von der Klemmenspannung der durch den Multiplexer 7 selektierten Zelle 2, 13, 14 und dem temperaturabhängigen Widerstand 8 ab.
Die Temperaturkurve des temperaturabhängigen Widerstandes 8 ist im Steuergerät 12 hinterlegt (gespeichert). Die Klemmspannung wird zuvor bei weggeschaltenen Widerstand 11 gemessen und im Speicher des Steuergerätes 12 gespeichert. Das Steuergerät 12 kann somit die Temperatur des temperaturabhängigen Widerstands 8 berechnen.

Der temperaturabhängige Widerstand 8 steht in thermischem Kontakt mit dem Verbindungselement 5.

Daraus ist somit die mittlere Zelltemperatur der über das Verbindungselement 5 verbundenen ersten Zelle 2, 13 und der zweiten Zelle 2, 14 ermittelbar.

### Bezugszeichenliste

- 1.: Überwachungsvorrichtung
- 2.: Zelle
- 3.: Erster Anschluss
- 4.: Zweiter Anschluss
- 5.: Verbindungselement
- 6.: Multiplexer-Verbindungsleitungen
- 7.: Multiplexer
- 8.: Temperaturabhängiger Widerstand
- 9.: AD-Verbindungsleitungen
- 10.: AD-Wandler
- 11.: Schaltwiderstand
- 12.: Steuereinheit
- 13.: Erste Zelle
- 14.: Zweite Zelle

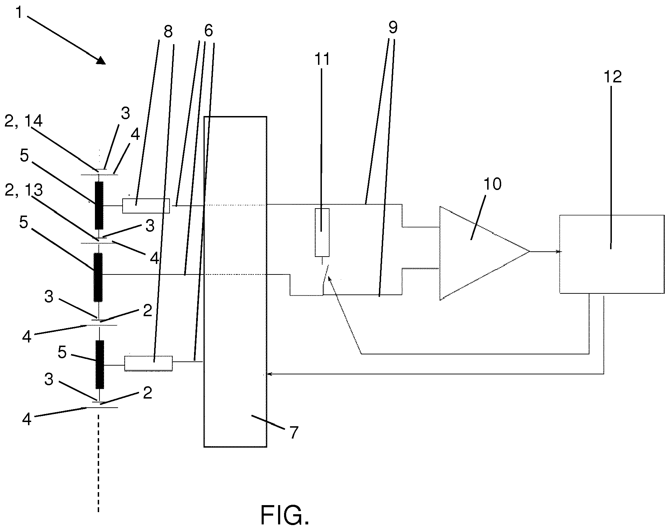

## Patentansprüche

1. Überwachungsvorrichtung (1) für ein Energiespeichersystem, wobei das Energiespeichersystem mehrere Zellen (2, 13, 14) aufweist, die jeweils einen ersten Anschluss (3) und einen zweiten Anschluss (4) aufweisen, wobei jeweils der erste Anschluss (3) einer ersten Zelle (13) mit dem zweiten Anschluss (4) einer zweiten Zelle (14) mittels jeweils einem Verbindungselement (5) verbunden ist, wobei jedes Verbindungselement (5) über jeweils eine Multiplexer-Verbindungsleitung (6) mit einem Multiplexer (7) verbunden ist, wobei in zumindest einer Multiplexer-Verbindungsleitung (6) ein temperaturabhängiger Widerstand (8) angeordnet ist, der in thermischem Kontakt mit zumindest einer Zelle (2,13,14) steht, wobei der Multiplexer (7) über zwei AD-Verbindungsleitungen (9) mit einem AD-Wandler (10) verbunden ist,
**dadurch gekennzeichnet, dass**
ein zuschaltbarer oder wegschaltbarer Schaltwiderstand (11) parallel zudem AD-Wandler (10) angeordnet ist derart, dass
die zwei AD-Verbindungsleitungen (9) über den Schaltwiderstand (11) verbindbar sind, und der Schaltwiderstand (11) über eine Steuereinheit (12) schaltbar ist.

2. Überwachungsvorrichtung (1) für ein Energiespeichersystem nach Anspruch 1,
**dadurch gekennzeichnet, dass** in zumindest jeder zweiten Multiplexer-Verbindungsleitung (6), insbesondere in jeder Multiplexer-Verbindungsleitung (6), jeweils ein temperaturabhängiger Widerstand (8) angeordnet ist.

3. Überwachungsvorrichtung (1) für ein Energiespeichersystem nach Anspruch 1 oder 2,
**dadurch gekennzeichnet, dass** der jeweilige temperaturabhängige Widerstand (8) an dem jeweiligen Verbindungselement (5) mechanisch befestigt ist.

4. Überwachungsvorrichtung (1) für ein Energiespeichersystem nach Anspruch 1,
**dadurch gekennzeichnet, dass** die Steuereinheit (12) mit dem AD-Wandler (10) verbunden ist.

5. Überwachungsvorrichtung (1) für ein Energiespeichersystem nach einem der Ansprüche 1 bis 4,
**dadurch gekennzeichnet, dass** der Multiplexer (7) über die Steuereinheit (12) steuerbar ist.

6. Überwachungsvorrichtung (1) für ein Energiespeichersystem nach einem der Ansprüche 1 bis 5,
**dadurch gekennzeichnet, dass** mittels des Multiplexers (7) und/oder durch die Steuereinheit (12) die Zellen (2, 13, 14) der Reihe nach zum AD-Wandler (10) durchschaltbar sind.

7. Überwachungsvorrichtung (1) für ein Energiespeichersystem nach einem der Ansprüche 1 bis 6,
**dadurch gekennzeichnet, dass** die Steuereinheit (12) so eingerichtet ist, dass eine Zellspannung messbar ist, wenn der Schaltwiderstand (11) weggeschaltet ist.

8. Überwachungsvorrichtung (1) für ein Energiespeichersystem nach einem der Ansprüche 1 bis 7,
**dadurch gekennzeichnet, dass** die Steuereinheit (12) so eingerichtet ist, dass die gemessene Zellspannung in der Steuereinheit (12) gespeichert wird.

9. Überwachungsvorrichtung (1) für ein Energiespeichersystem nach einem der Ansprüche 1 bis 8,
**dadurch gekennzeichnet, dass** die Steuereinheit (12) so eingerichtet ist, dass die Spannung am Schaltwiderstand (11) messbar ist, wenn der Schaltwiderstand (11) zugeschaltet ist.

10. Überwachungsvorrichtung (1) für ein Energiespeichersystem nach Anspruch 9,
**dadurch gekennzeichnet, dass** die Steuereinheit (12) so eingerichtet ist, dass bei der am Schaltwiderstand (11) gemessenen Spannung der Strom durch den Schaltwiderstand (11) berechnet wird.

11. Überwachungsvorrichtung (1) für ein Energiespeichersystem nach einem der Ansprüche 7 bis 10,
**dadurch gekennzeichnet, dass** die Steuereinheit (12) so eingerichtet ist, dass mit der zuvor gemessenen und gespeicherten Zellspannung und dem berechneten Strom durch den Schaltwiderstand (11) der Widerstandswert des temperaturabhängigen Widerstands (8) berechnet wird.

12. Überwachungsvorrichtung (1) für ein Energiespeichersystem nach einem der voranstehenden Ansprüche,
**dadurch gekennzeichnet, dass** die Steuereinheit (12) so eingerichtet ist, dass ein Temperatur-Widerstand Zusammenhang des temperaturabhängigen Widerstands (8) im Speicher der Steuereinheit (12) hinterlegt ist.

13. Überwachungsvorrichtung (1) für ein Energiespeichersystem nach Anspruch 12,
**dadurch gekennzeichnet, dass** die Steuereinheit (12) so eingerichtet ist, dass die Temperatur des temperaturabhängigen Widerstands mit Hilfe des Temperatur-Widerstand Zusammenhangs berechnet wird.

14. Überwachungsvorrichtung (1) für ein Energiespeichersystem nach Anspruch 13,
**dadurch gekennzeichnet, dass** die Steuereinheit (12) so eingerichtet ist, dass mit der berechneten Temperatur des temperaturabhängigen Widerstands (8) die Temperaturen der zum temperaturabhängigen Widerstand (8) benachbarten Zellen berechnet werden.

15. Überwachungsvorrichtung (1) für ein Energiespeichersystem nach einem der voranstehenden Ansprüche ,
**dadurch gekennzeichnet, dass** die Steuereinheit (12) so eingerichtet ist, dass ein Ladungsausgleich zwischen den Zellen (2, 13, 14) durchführbar ist, wenn der Schaltwiderstand (11) zugeschaltet ist und der Multiplexer (7) derart geschaltet ist, dass ein ausreichend großes Zeitfenster für eine Entladung einer Zelle (2, 13, 14) bereitgestellt wird.

16. Verfahren zur Überwachung eines Energiespeichersystems, wobei das Energiespeichersystem eine Steuereinheit (12) und mehrere Zellen (2, 13, 14) aufweist, die jeweils einen ersten Anschluss (3) und einen zweiten Anschluss (4) aufweisen, wobei der erste Anschluss (3) einer ersten Zelle (2, 13) mit dem zweiten Anschluss (4) einer zweiten Zelle (2, 14) mittels jeweils einem Verbindungselement (5) verbunden ist, wobei durch die Steuereinheit (12) zumindest eine jeweilige mittlere Zelltemperatur der über das jeweilige Verbindungselement (5) verbundenen ersten Zelle (2, 13) und zweiten Zelle (2, 14) berechnet wird,
**dadurch gekennzeichnet, dass** die jeweilige mittlere Zelltemperatur mittels jeweils einem temperaturabhängigen Widerstand (8) über die jeweilige gemessene Zellspannung der Zelle (2,13,14) und einen jeweiligen berechneten Strom durch einen zugeschalteten Schaltwiderstand (11) berechnet wird.

17. Verfahren zur Überwachung eines Energiespeichersystems nach Anspruch 16,
**dadurch gekennzeichnet, dass** der jeweilige Strom durch den zugeschalteten Schaltwiderstand (11) über eine mittels eines AD-Wandlers (10) ermittelte jeweilige Spannung am zugeschalteten Schaltwiderstand (11) berechnet wird.

18. Verfahren zur Überwachung eines Energiespeichersystems nach Anspruch 16,
**dadurch gekennzeichnet, dass** die über die jeweiligen Verbindungselemente (5) gemessenen Zellspannungen mittels eines Multiplexers (7) der Reihe nach zu dem AD-Wandler (10) durchgeschaltet werden.

## Claims

1. Monitoring device (1) for an energy storage system, wherein the energy storage system comprises a plurality of cells (2, 13, 14), each having a first terminal (3) and a second terminal (4), wherein in each case the first terminal (3) of a first cell (13) is connected to the second terminal (4) of a second cell (14) by means of a respective connecting element (5), wherein each connecting element (5) is connected to a multiplexer (7) via a respective multiplexer connection line (6), wherein a temperature-dependent resistor (8) is arranged in at least one multiplexer connection line (6), said resistor being in thermal contact with at least one cell (2, 13, 14), wherein the multiplexer (7) is connected to an AD converter (10) via two AD connection lines (9),
**characterized in that**
a switchable resistor (11) which can be connected or disconnected is arranged in parallel with the AD converter (10) such that
the two AD connection lines (9) can be connected via the switchable resistor (11) and the switchable resistor (11) can be switched via a control unit (12).

2. Monitoring device (1) for an energy storage system according to claim 1,
**characterized in that** a respective temperature-dependent resistor (8) is arranged in at least every second multiplexer connection line (6), in particular in every multiplexer connection line (6).

3. Monitoring device (1) for an energy storage system according to claim 1 or 2,
**characterized in that** the respective temperature-dependent resistor (8) is mechanically fastened to the respective connecting element (5).

4. Monitoring device (1) for an energy storage system according to claim 1,
**characterized in that** the control unit (12) is connected to the AD converter (10).

5. Monitoring device (1) for an energy storage system according to one of claims 1 to 4,
**characterized in that** the multiplexer (7) can be controlled via the control unit (12).

6. Monitoring device (1) for an energy storage system according to one of claims 1 to 5,
**characterized in that** the cells (2, 13, 14) can be connected to the AD converter (10) one after the other by means of the multiplexer (7) and/or by the control unit (12).

7. Monitoring device (1) for an energy storage system according to one of claims 1 to 6,
**characterized in that** the control unit (12) is configured such that a cell voltage can be measured when the switchable resistor (11) is disconnected.

8. Monitoring device (1) for an energy storage system according to one of claims 1 to 7,
**characterized in that** the control unit (12) is configured such that the measured cell voltage is stored in the control unit (12) .

9. Monitoring device (1) for an energy storage system according to one of claims 1 to 8,
**characterized in that** the control unit (12) is configured such that the voltage across the switchable resistor (11) can be measured when the switchable resistor (11) is connected.

10. Monitoring device (1) for an energy storage system according to claim 9,
**characterized in that** the control unit (12) is configured such that the current through the switchable resistor (11) is calculated for the voltage measured across the switchable resistor (11).

11. Monitoring device (1) for an energy storage system according to one of claims 7 to 10,
**characterized in that** the control unit (12) is configured such that the resistance value of the temperature-dependent resistor (8) is calculated by virtue of the previously measured and stored cell voltage and the calculated current through the switchable resistor (11).

12. Monitoring device (1) for an energy storage system according to one of the preceding claims,
**characterized in that** the control unit (12) is configured such that a temperature/resistance relationship of the temperature-dependent resistor (8) is stored in the memory of the control unit (12).

13. Monitoring device (1) for an energy storage system according to claim 12,
**characterized in that** the control unit (12) is configured such that the temperature of the temperature-dependent resistor is calculated by means of the temperature/resistance relationship.

14. Monitoring device (1) for an energy storage system according to claim 13,
**characterized in that** the control unit (12) is configured such that the temperatures of the cells adjacent to the temperature-dependent resistor (8) are calculated by virtue of the calculated temperature of the temperature-dependent resistor (8).

15. Monitoring device (1) for an energy storage system according to one of the preceding claims,
**characterized in that** the control unit (12) is configured such that a charge balancing between the cells (2, 13, 14) can be carried out when the switchable resistor (11) is connected and the multiplexer (7) is switched such that a sufficiently large time window for discharging a cell (2, 13, 14) is provided.

16. Method for monitoring an energy storage system, wherein the energy storage system comprises a control unit (12) and a plurality of cells (2, 13, 14), each having a first terminal (3) and a second terminal (4), wherein the first terminal (3) of a first cell (2, 13) is connected to the second terminal (4) of a second cell (2, 14) by means of a respective connecting element (5), wherein at least one respective average cell temperature of the first cell (2, 13) and second cell (2, 14) connected via the respective connecting element (5) is calculated by the control unit (12),
**characterized in that** the respective average cell temperature is calculated by means of a respective temperature-dependent resistor (8) via the respective measured cell voltage of the cell (2, 13, 14) and a respective calculated current through a connected switchable resistor (11).

17. Method for monitoring an energy storage system according to claim 16,
**characterized in that** the respective current through the connected switchable resistor (11) is calculated via a respective voltage across the connected switchable resistor (11), said voltage being determined by means of an AD converter (10).

18. Method for monitoring an energy storage system according to claim 16,
**characterized in that** the cell voltages measured via the respective connecting elements (8) are connected to the AD converter (10) one after the other by means of a multiplexer (7) .

## Revendications

1. Dispositif de surveillance (1) pour un système d'accumulation d'énergie, ledit système d'accumulation d'énergie comportant plusieurs cellules (2, 13, 14) présentant chacune une première connexion (3) et une deuxième connexion (4), la première connexion (3) d'une première cellule (13) étant reliée à la deuxième connexion (4) d'une deuxième cellule (14) au moyen d'un élément de liaison (5), chaque élément de liaison (5) étant relié à un multiplexeur (7) par une ligne de raccordement (6) de multiplexeur, une résistance dépendante de la température (8) étant agencée sur au moins une ligne de raccordement (6) de multiplexeur, laquelle est en contact thermique avec au moins une cellule (2, 13, 14), le multiplexeur (7) étant relié à un convertisseur analogique-numérique (10) par deux lignes de liaison analogique-numérique (9),
**caractérisé en ce que** :
une résistance de commutation (11) activable ou désactivable est montée en parallèle au convertisseur analogique-numérique (10), de telle manière que les deux lignes de liaison analogique-numérique (9) peuvent être raccordées par la résistance de commutation (11), et la résistance de commutation (11) est commutable par une unité de commande (12).

2. Dispositif de surveillance (1) pour un système d'accumulation d'énergie selon la revendication 1, **caractérisé en ce que**, sur au moins chaque deuxième ligne de raccordement (6) de multiplexeur, en particulier sur chaque ligne de raccordement (6) de multiplexeur, est montée une résistance dépendante de la température (8).

3. Dispositif de surveillance (1) pour un système d'accumulation d'énergie selon la revendication 1 ou 2, **caractérisé en ce que** chaque résistance dépendante de la température (8) est mécaniquement fixée sur l'élément de liaison (5) correspondant.

4. Dispositif de surveillance (1) pour un système d'accumulation d'énergie selon la revendication 1, **caractérisé en ce que** l'unité de commande (12) est reliée au convertisseur analogique-numérique (10).

5. Dispositif de surveillance (1) pour un système d'accumulation d'énergie selon l'une des revendications 1 à 4, **caractérisé en ce que** le multiplexeur (7) peut être commandé par l'unité de commande (12).

6. Dispositif de surveillance (1) pour un système d'accumulation d'énergie selon l'une des revendications 1 à 5, **caractérisé en ce que** les cellules (2, 13, 14) sont commutables en série au convertisseur analogique-numérique (10) au moyen du multiplexeur (7) et/ou de l'unité de commande (12).

7. Dispositif de surveillance (1) pour un système d'accumulation d'énergie selon l'une des revendications 1 à 6, **caractérisé en ce que** l'unité de commande (12) est configurée de manière à permettre la mesure d'une tension de cellule quand la résistance de commutation (11) est désactivée.

8. Dispositif de surveillance (1) pour un système d'accumulation d'énergie selon l'une des revendications 1 à 7, **caractérisé en ce que** l'unité de commande (12) est configurée de manière à mémoriser dans l'unité de commande (12) la tension de cellule mesurée.

9. Dispositif de surveillance (1) pour un système d'accumulation d'énergie selon l'une des revendications 1 à 8, **caractérisé en ce que** l'unité de commande (12) est configurée de manière à permettre la mesure de la tension sur la résistance de commutation (11) quand la résistance de commutation (11) est activée.

10. Dispositif de surveillance (1) pour un système d'accumulation d'énergie selon la revendication 9, **caractérisé en ce que** l'unité de commande (12) est configurée de manière à calculer le courant traversant la résistance de commutation (11) par la tension mesurée sur la résistance de commutation (11).

11. Dispositif de surveillance (1) pour un système d'accumulation d'énergie selon l'une des revendications 7 à 10, **caractérisé en ce que** l'unité de commande (12) est configurée de manière à calculer la valeur de la résistance dépendante de la température (8) avec la tension de cellule précédemment mesurée et mémorisée et le courant calculé par la résistance de commutation (11).

12. Dispositif de surveillance (1) pour un système d'accumulation d'énergie selon l'une des revendications précédentes, **caractérisé en ce que** l'unité de commande (12) est configurée de manière à sauvegarder dans l'unité de commande (12) un rapport résistance-température de la résistance dépendante de la température (8).

13. Dispositif de surveillance (1) pour un système d'accumulation d'énergie selon la revendication 12, **caractérisé en ce que** l'unité de commande (12) est configurée de manière à calculer la température de la résistance dépendante de la température à l'aide du rapport résistance-température.

14. Dispositif de surveillance (1) pour un système d'accumulation d'énergie selon la revendication 13, **caractérisé en ce que** l'unité de commande (12) est configurée de manière à calculer les températures des cellules contiguës à la résistance dépendante de la température (8) avec la température calculée de la résistance dépendante de la température (8).

15. Dispositif de surveillance (1) pour un système d'accumulation d'énergie selon l'une des revendications précédentes, **caractérisé en ce que** l'unité de commande (12) est configurée de manière à permettre l'exécution d'une compensation de charge entre les cellules (2, 13, 14) lorsque la résistance de commutation (11) est activée et le multiplexeur (7) est commuté de manière à ménager une fenêtre temporelle suffisamment grande pour la décharge d'une cellule (2, 13, 14).

16. Procédé de surveillance d'un système d'accumulation d'énergie, ledit système d'accumulation d'énergie comportant une unité de commande (12) et plusieurs cellules (2, 13, 14) présentant chacune une première connexion (3) et une deuxième connexion (4), la première connexion (3) d'une première cellule (2, 13) étant reliée à la deuxième connexion (4) d'une deuxième cellule (2, 14) au moyen d'un élément de liaison (5), au moins une température de cellule moyenne de la première cellule (2, 13) et de la deuxième cellule (2, 14) reliées par l'élément de liaison (5) respectif étant calculée par l'unité de commande (12),
**caractérisé en ce que** la température de cellule moyenne est calculée au moyen d'une résistance dépendante de la température (8) par l'intermédiaire de la tension mesurée de la cellule (2, 13, 14) et d'un courant calculé par une résistance de commutation (11) activée.

17. Procédé de surveillance d'un système d'accumulation d'énergie selon la revendication 16, **caractérisé en ce que** le courant est calculé par la résistance de commutation (11) activée à l'aide d'une tension sur la résistance de commutation (11) activée déterminée au moyen d'un convertisseur analogique-numérique (10).

18. Procédé de surveillance d'un système d'accumulation d'énergie selon la revendication 16, **caractérisé en ce que** les tensions de cellule mesurées par les éléments de liaison (5) sont commutées en série au convertisseur analogique-numérique (10) au moyen d'un multiplexeur (7).
